# EUROPÄISCHE PATENTSCHRIFT

(11) **EP 1 154 564 B1**
(45) Veröffentlichungstag und Bekanntmachung des Hinweises auf die Patenterteilung: **10.09.2008**
(21) Anmeldenummer: 01111587.0
(22) Anmeldetag: 12.05.2001
(51) Int. Cl.: H03F 1/08, H03F 1/30

(54) **Zweistufiger Verstärker**
Two stage amplifier
Amplificateur à deux étages

(30) Priorität: 13.05.2000 DE 10023524
(43) Veröffentlichungstag der Anmeldung: 14.11.2001
(73) Patentinhaber: Micronas GmbH, 79108 Freiburg i. Br. (DE)
(72) Erfinder: Theus, Ulrich, Dr., 79194 Gundenfilgen (DE); Kessel, Jürgen, Dipl.-Ing., 79102 Freiburg (DE)

(56) Entgegenhaltungen:
- EP-A- 0 638 996
- EP-A- 0 688 096
- EP-A- 0 689 286
- EP-A- 0 711 026

## Beschreibung

Die Erfindung betrifft einen zweistufigen Verstärker, der zur Verstärkung von Wechselspannungs- und Gleichspannungssignalen geeignet ist. Dabei soll jedoch berücksichtigt werden, daß die zur Verfügung stehenden Versorgungsspannungen auch relativ klein sein können, wodurch im Betriebsfall der Ausgangspegel der ersten Verstärkerstufe gegebenenfalls nicht mehr mit dem erforderlichen Eingangspegel der zweiten Verstärkerstufe zusammenpaßt. Im Extremfall befindet sich der Verstärker dadurch in einem oberen oder unteren Begrenzungszustand, und die zugehörige Verstärkung wird zu Null. Dieser Effekt tritt insbesondere bei CMOS-Verstärkern durch die relativ großen Schwellenspannungen der MOS-Transistoren auf.

In IEEE Journal of Solid-State Circuits, Band 33 Nr.7, Juli 1998, Seiten 956-962, "Embedded 5 V-to-3.3 V Voltage Regulator for Supplying Digital IC's in 3.3 V CMOS Technology" wird eine vollintegrierte Spannungsversorgung beschrieben, bei der auf dem Chip eine 5 Volt Versorgungsspannung auf 3,3 Volt heruntergesetzt wird. Die niedere Versorgungsspannung von 3,3 Volt dient dazu, eine für niederen Stromverbrauch ausgelegte CMOS Digitalschaltung zu speisen. In einem Ausführungsbeispiel des Spannungsversorgers wird der Gateanschluss eines n-Kanal-Ausgangstransistors von einem Komparator über eine Ladungspumpe angesteuert, um die erforderliche Ansteuerspannung zu erzeugen. Der Komparator und der n-Kanal-Ausgangstransistor, der als Sourcefolger geschaltet ist, bilden dabei einen zweistufigen Verstärker mit einem invertierenden und einem nichinvertierenden Eingang. Als Ladungspumpe dient ein Spannungsverdoppler, dem als Eingangsgröße die Ausgangsspannung des Komparators zugeführt wird. Weil die jeweilige Last am Verstärkerausgang nicht bekannt ist, wird aus Stabilitätsgründen die rückgeführte Spannung nicht am Verstärkerausgang direkt abgegriffen, sondern an einer Nachbildung. Für die Regelung des Spannungsverdopplers und damit für die Regelung des Verstärkers wird kein linearer Regler verwendet, sondern in der Art eines Zweipunktreglers lediglich überprüft, ob die rückgeführte Spannung größer oder kleiner als ein vorgegebener Vergleichswert ist. Je nach Abweichung wird über die Ladungspumpe die Gatespannung für den n-Kanal-Ausgangstransistor erhöht oder erniedrigt. Für allgemeine Verstärkeranwendungen ist diese Anordnung wenig geeignet.

Aufgabe der Erfindung ist es, einen verbesserten zweistufigen Verstärker für allgemeine Verstärkungsanwendungen anzugeben, der an reduzierte Versorgungsspannungen angepasst ist.

Die Lösung der Aufgabe erfolgt nach den Merkmalen des Anspruchs 1. Sie besteht darin, daß die erste und zweite Verstärkungsstufe durch einen Koppelkondensator galvanisch voneinander getrennt sind und trotzdem Signale mit beliebig niederen Frequenzen verstärken können. Mittels einer an den Koppelkondensator angeschlossenen Ladungspumpe wird hierzu eine im Wesentlichen konstante und erdfreie Vorspannung an den Koppelkondensator angelegt. Durch die Ladungspumpe können bei Bedarf auch Vorspannungen erzeugt werden, die außerhalb des Versorgungsbereiches liegen. Sogar wenn die erste Verstärkerstufe ein Transkonduktanzverstärker ist, arbeitet diese Anordnung zufriedenstellend, denn der Ausgangsstrom der ersten Stufe wird gleichsam über den Koppelkondensator auf den MOS-Eingang der zweiten Verstärkungsstufe übertragen. Dies gilt sowohl für Gleich- als auch Wechselsignale, sofern sie frequenzmäßig deutlich unterhalb der Pumpfrequenz liegen. Diese zweistufige Verstärkeranordnung ist somit geeignet, Signale mit Gleich- und Wechselanteilen zu verstärken.

Die Ladungspumpe erzeugt zwischen ihren beiden Ausgängen eine erdfreie Spannung, die in einem festen Verhältnis zu einer zugeführten Referenzspannung steht. Wenn die erste Stufe als ein Transkonduktanzverstärker ausgebildet ist, dann stellt der Eingang der zweiten Verstärkungsstufe einen dominanten Pol dar. Für Stabilitätszwecke, insbesondere im rückgekoppelten Verstärkungsfall, kann dieser dominante Pol durch einen mitintegrierbaren Kompensationskondensator vergrößert werden, so daß keine Stabilitätsprobleme auftreten. Damit die Ladungspumpe als möglichst erdfreie Spannungsquelle arbeitet, ist es zweckmäßig, zur galvanischen Trennung des Koppelkondensators von der Ladungspumpe, die Ausgangsstrompfade mittels Pumpkondensatoren in einer gegen Streukapazitäten unempfindlichen Anordnung aufzutrennen. Dann kann über diese Pumpkondensatoren kein Strom von der ersten oder zweiten Verstärkungsstufe nach Masse oder dem Versorgungsanschluß abfließen. Die verbleibenden Streukapazitäten des Koppelkondensators und der beiden Pumpkondensatoren liegen nach Masse und damit parallel zum Kompensationskondensator, dessen Wirkung als Pol dadurch vergrößert wird. Der Strom zum Auf- oder Entladen der parasitären Kapazitäten muß aber nicht von der ersten Stufe aufgebracht werden, sondern wird von der Ladungspumpe geliefert. Der durch restliche Streukapazitäten verlorene Strom führt also nicht zu einer Offsetspannung am Eingang der ersten Stufe.

Die Größe des Koppelkondensators bestimmt sich in Abhängigkeit vom maximalen Ausgangsstrom der ersten Stufe und der Taktrate der Ladungspumpe. Als Bemessungsregel ist darauf zu achten, daß der maximale Ausgangsstrom der ersten Stufe vom Koppelkondensator für die Dauer eines Halbtaktes der Ladungspumpe aufgenommen werden kann ohne daß die erste Stufe den erlaubten Ausgangsspannungsbereich verläßt. Andererseits sollte der Koppelkondensator kleiner als der den dominanten Pol bildende Kondensator am Eingang der zweiten Stufe sein. Lassen sich beide Dimensionierungsvorschriften nicht mehr einhalten, dann ist notfalls die Taktfrequenz der Ladungspumpe zu erhöhen.

Ladungspumpen zur Spannungserhöhung in CMOS-Technik sind beispielsweise ausführlich in IEEE Journal of Solid-State Circuits, Band 33, Nr. 3, März 1998, Seiten 410-416, in dem Aufsatz "A High-Efficiency CMOS Voltage Doubler" beschrieben. Derartige Schaltungen erfordern einen nichtüberlappenden Zweiphasentakt, der über zwei Pumpkondensatoren, elektronische Schalter oder nichtlineare Bauelemente eine Spannungserhöhung einer zugeführten Referenzspannung realisiert. Der nichtüberlappende Zweiphasentakt wird dabei in der Regel in einem Pumpgenerator aus einem zugeführten Taktsignal mit dem Puls-Pausen-Verhältnis von 1:1 gebildet.

Ein vorteilhaftes Ausführungsbeispiel des zweistufigen Verstärkers nach der Erfindung wird anhand der Figuren der Zeichnung im folgenden näher beschrieben:
- Fig. 1: zeigt schematisch als Blockschaltbild einen zweistufigen Verstärker nach der Erfindung und
- Fig. 2: zeigt ein Ausführungsbeispiel für eine dabei verwendete Ladungspumpe.

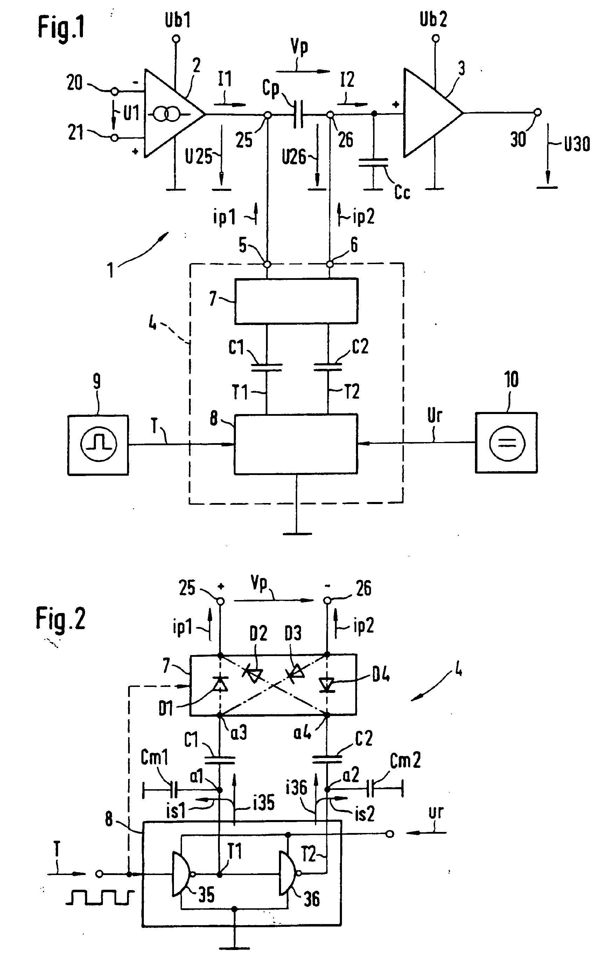

Die Schaltung von Fig. 1 zeigt die wesentlichen Funktionseinheiten eines zweistufigen Verstärkers 1 nach der Erfindung. Eine erste und zweite Verstärkerstufe 2, 3, die im Folgenden meist kurz als Stufe bezeichnet werden, sind seriell über einen Koppelkondensator Cp miteinander verbunden. Der erste Anschluss 25 des Koppelkondensators liegt am Ausgang der ersten Stufe 2 und der zweite Anschluss 26 am Eingang der zweiten Stufe 3. Die erste Stufe 2 ist als Transkonduktanzverstärker mit Differenzeingang ausgeführt. Der invertierende Eingang 20 dient beispielsweise als Eingang für das am Ausgang 30 der zweiten Stufe 3 abgegriffene Ausgangssignal U30. Der nichtinvertierende Eingang 21 der ersten Stufe 2 dient als Signaleingang. Die Spannungsversorgung der ersten und zweiten Stufe 2, 3 erfolgt über eine gemeinsame Versorgungsspannung oder über zwei getrennte Versorgungsspannungen Ub1 bzw. Ub2, wobei im letzten Fall die zweite Versorgungsspannung Ub2 in der Regel niedriger als die erste Versorgungsspannung Ub1 ist.

Die erste Stufe 2 setzt als Transkonduktanzverstärker die zwischen den Eingängen 20, 21 liegende Differenzspannung U1 in einen Ausgangsstrom I1 um. Für die weitere Betrachtung ist zunächst angenommen, daß der Koppelkondensator Cp kurzgeschlossen ist, wodurch der Ausgangsstrom I1 direkt auf den einzigen nichtinvertierenden Eingang der zweiten Stufe 3 gelangt. Die zweite Stufe ist ein Spannungsverstärker und hat einen hochohmigen Eingang. Dabei stellen die Gatekapazitäten der Eingangstransistoren für den Ausgangsstrom I1, gegebenenfalls in Verbindung mit einem zusätzlichen Kompensationskondensator Cc, eine kapazitive Belastung dar, die aus Stabilittätsgründen den dominanten Pol der Regelschleife mit dem zweistufigen Verstärker 1 bilden soll. Es fließt dann solange ein Strom I1 aus der ersten Stufe 2, der den kapazitiven Eingang der zweiten Stufe 3 im richtigen Sinn umlädt, bis über die rückgeführte Ausgangsspannung U30 die Eingangsdifferenzspannung U 1 zu Null geworden ist. Wenn dieser Punkt erreicht ist, ist der Ausgangsstrom I1 ebenfalls zu Null geworden.

Mit dem Koppelkondensator Cp soll nach der Erfindung die Verstärkungsfunktion der beiden Stufen 2, 3 auch dann noch aufrecht erhalten werden, wenn der Ausgangsspannungsbereich der ersten Stufe 2 nicht mehr oder nur noch teilweise mit dem erforderlichen Eingangsspannungsbereich der zweiten Stufe 3 zusammenpaßt. Dabei kann der Eingangsspannungsbereich der zweiten Stufe 3 teilweise auch außerhalb der Versorgungsspannung Ub1der ersten Stufe 2 liegen. Der Koppelkondensator Cp ermöglicht in Verbindung mit einer Ladungspumpe 4 den erforderlichen Spannungsversatz zwischen dem Ausgang der ersten Stufe 2 und dem Eingang der zweiten Stufe 3. Die Spannung über den Koppelkondensator Cp wird durch die Ladungspumpe 4 im zeitlichen Mittel konstant gehalten. Dabei ist der Momentanwert auch signalabhängig, nämlich vom Signal U1. Die Ladungspumpe 4 erzwingt über ihren ersten und zweiten Ausgang 5, 6 eine Vorspannung Vp, die als erdfreie Spannung den Anschlüssen 25, 26 des Koppelkondensators Cp zugeführt ist. Die Referenz für die Vorspannung Vp bildet eine Referenzspannung ur aus einer mitintegrierten Referenzspannungsquelle 10. Der Pumpvorgang selbst ist von einem Takt T gesteuert, der dem zweistufigen Verstärker 1 entweder von außen zugeführt oder mittels eines mitintegrierten Taktgenerators 9 auf dem gleichen Chip gebildet ist.

Die Ladungspumpe 4 erzeugt am ersten bzw. zweiten Ausgang 5, 6 einen ersten bzw. zweiten Pumpstrom ip1, ip2. Der erste Pumpstrom ip1 überlagert sich mit dem Ausgangsstrom I1 und bestimmt die Ausgangsspannung U25 der ersten Stufe 2. Die Auf-oder Entladung der Eingangskapazität der zweiten Stufe und des dort parallel angeschlossenen Kompensationskondensators Cc erfolgt über einen Lade-Entladestrom I2, der im eingeschwungenem Zustand des zweistufigen Verstärkers 1 wie der Ausgangsstrom I1 der ersten Stufe 2 den Wert Null hat. Die Eingangsspannung der zweiten Stufe 3 und damit die Spannung U26 am zweiten Anschluß 26 des Koppelkondensators Cp ist vom Integral des Eingangsstromes I2 und dem Integral des zweiten Pumpstromes ip2 abhängig. Die beiden Pumpströme ip1, ip2 stellen sich dabei entsprechend dem Spannungsübersetzungsverhältnis der Ladungspumpe 4 so ein, daß sich im zeitlichen Mittel die vorgegebene Vorspannung Vp nicht ändert, sondern konstant erhalten bleibt.

Die Funktionsweise der Ladungspumpe 4 zur Erzeugung der konstanten und erdfreien Vorspannung Vp, wird anhand des einfachen Ausführungsbeispiels von Fig. 2 beschrieben. Zunächst ist als Steuertakt für den Pumpgenerator 8 ein rechteckförmiger Takt T erforderlich, der zweckmäßigerweise und aus Symmetriegründen für die gesamte Verstärkeranordnung 1 ein Puls-Pausen-Verhältnis von 1:1 hat. Der Takt T steuert in Reihenschaltung einen ersten und zweiten Inverter 35, 36 an, an deren Ausgang ein erster bzw. ein dazu gegenphasiger zweiter Pumptakt T1, T2 abgreifbar ist. Zweckmäßigerweise werden für die Inverter 35, 36 einfache CMOS-Inverter verwendet, weil dann der Hub der beiden Pumptakte T1, T2 die volle Spannungsdifferenz zwischen der Spannungsversorgung der Inverter und dem Massenanschluß umfaßt. Als Spannungsversorgung dient die geregelte Referenzspannung ur aus der Referenzspannungsquelle 10, vergl. Fig. 1. Bei anderen Anwendungen kann es sinnvoll sein, daß die Spannungsversorgung der beiden Inverter 35, 36 nicht an die separate Referenzspannungsquelle 10 sondern an die Signalspannung U1 gekoppelt ist. Mit den Pumptakten T1, T2 werden ein erster und zweiter Pumpkondensator C1, C2 über die zugehörigen Anschlüsse a1, a2 angesteuert, deren abgewandte Anschlüsse a3, a4 jeweils mit einem Eingang der elektronischen Schaltmittel 7 verbunden sind. Dort werden in Abhängigkeit von der Phase des Taktes T und damit auch von der Phase der Pumptakte T1, T2 die Strompfade für die Pumpströme ip1, ip2 zu den beiden Anschlußkontakten 25, 26 des angeschlossenen Koppelkondensators Cp geschaltet, vergl. Fig. 1. Dabei findet durch die beiden Pumptakte T1, T2 gesteuert eine Aufladung bzw. eine Entladung des ersten bzw. zweiten Anschlußkontaktes 25, 26 statt, sofern die Vorspannung Vp vom vorgegebenen Wert abweicht. Die jeweils mittels nicht dargestellter elektronischer Schalter gleichzeitig aktivierten Strompfade in den Schaltmitteln 7 sind in der einen Phase als gestrichelte und in der anderen Phase als strichpunktierte Linien dargestellt. Beispielsweise wird der gestrichelt dargestellten Strompfad zwischen den Anschlüssen a3, 25 während des oberen Schaltpegels des Pumptaktes T1 und der strichpunktierte Strompfad zwischen den Anschlüssen a4, 26 während des unteren Schaltpegels (=Masse) des Pumptaktes T2 aktiviert. Entsprechend umgekehrt ist es während der anderen Phase der Pumptakte T1, T2. Durch diese Steuerung wird am Anschluß 25 ein höheres Potential eingestellt als am Anschluß 26, dessen Potential um die Vorspannung Vp darunter liegt. Die zur Ladungsanpassung erforderlichen Pumpströme ip1, ip2 sind relativ klein und die erforderliche Stromflußzeit damit kurz, so daß sie im Wesentlichen unabhängig von der Dauer und Periode der Pumptakte T1, T2 nur während der vorderen oder hinteren Taktflanke auftreten.

Anstatt elektronische Schalter im Schaltungsblock 7 zu verwenden, können wie bei Ladungspumpen üblich auch nichtlineare Bauelemente die jeweiligen Strompfade öffnen und schließen. Dies ist in Fig. 2 durch die eingefügten Dioden D1, D2, D3, D4 symbolisiert. Überschreitet die Spannung am angeschlossenen Pumpkondensator C1, C2 die Flußspannung der jeweiligen Diode, dann wird sie leitend, und es fließt ein Pumpstrom ip1, ip2. Durch die Auf- oder Entladung am angeschlossenen Koppelkondensatoranschluß 25, 26 verkleinert sich die Potentialdifferenz gegenüber dem gepumpten Potential, so daß die Flußspannung nicht mehr überschritten wird. Damit ist der Pumpvorgang für die jeweilige Taktphase beendet. Während der anderen Taktphase ist die Diode dann gesperrt, so daß kein Strom in der falschen Richtung fließen kann.

Aus Fig. 2 ist auch leicht zu erkennen, daß die Ströme is 1, is2 zum Auf- oder Entladen der mit den Pumpkondensatoren C1, C2 verbundenen parasitären Kapazitäten Cm1, Cm2 nicht aus der ersten Stufe 2 über den Anschluß 25 kommen, sondern allein von dem Pumpgenerator 8 geliefert werden. Die bei Pumpschaltung übliche Auf- und Entladung über den gesamten Spannungshub ur findet nur bei den parasitären Kapazitäten Cm1, Cm2 statt. Die Spannungen über die Pumpkondensatoren C1, C2 und den Koppelkondensator Cp sind im Gegensatz dazu im Wesentlichen konstant und werden allenfalls nur geringfügig geändert. Über die Anschlüsse 25, 26 kann wie bereits erwähnt kein Gleichstrom nach Masse abfließen, die Pumpkondensatoren C1, C2 verhindern dies. Der Auf- und Entladestrom für die parasitären Kapazitäten Cm1, Cm2 wird durch jeweils einen abgezweigten Anteil is1, is2 der Ursprungs-Pumpströme i35, i36 aufgebracht, die letztendlich über die Spannungsversorgung der Inverter 25, 26 von der Referenzquelle 10 gespeist sind. Der jeweilige andere Anteil der Ursprungs-Pumpströme i35, i36 bildet den ersten oder zweiten Pumpstrom ip1, ip2 am Ausgang der Ladungspumpe 4.

Die Funktion der Ladungspumpe erzeugt eine Störfrequenz im verstärkten Signal am Ausgang des zweistufigen Verstärkers 1. Die Störfrequenz liegt bei der doppelten Taktrate des Taktes T und kann durch die Vorgabe der Taktrate in Frequenzbereiche außerhalb der Signalfrequenzen gelegt werden, wo sie dann leicht durch Tiefpaßfilter unterdrückt werden kann.

### Bezugszeichenliste

- 1: zweistufiger Verstärker
- 2 / 3: 1. / 2. (Verstärker-) Stufe
- 4: Ladungspumpe
- 5 / 6: 1./2. Ausgang (der Ladungspumpe)
- 7: Schaltmittel
- 8: Pumpgenerator
- 9: Taktgenerator
- 10: Referenzspannungsquelle
- 20: invertierender Eingang
- 21: nichtinvertierender Eingang
- 25/26: 1. / 2. Anschluß (des Koppelkondensators)
- 30: Ausgang (der 2. Stufe)
- 35 / 36: 1. / 2. Inverter
- Vp: Vorspannung
- Ub1: 1. Versorgungsspannung (ungeregelt)
- Ub2: 2. Versorgungsspannung
- ur: Referenzspannung
- I1: 1. Lade-Entladestrom = Ausgangsstrom
- I2: 2. Lade-Entladestrom = Eingangsstrom
- Cp: Koppelkondensator
- C1 / C2: 1./2. Pumpkondensator
- Cc: Kompensationskondensator
- Cm1 / Cm2: Streukapazität
- D1 / D4: 1. bis 4. Diode
- T: Takt
- T1 / T2: 1./2. Pumptakt
- ip1 / ip2: 1./2. Pumpstrom
- i35 / i36: 1./2. Versorgungs-Pumpstrom
- is1 / is2: parasitäre Ströme
- U 1: Eingangsdifferenzspannung
- U25 / U26: Spannung am Anschluß 25 oder 26
- U30: Ausgangsspannung (der 2. Stufe)

## Patentansprüche

1. Zweistufiger Verstärker (1), dessen erste und zweite Stufe (2, 3) in Reihenschaltung über einen Koppelkondensator (Cp) miteinander verbunden sind, mit
- einer Ladungspumpe (4), die eine über dem Koppelkondensator (Cp) liegende Vorspannung (Vp) erzeugt, die im zeitlichen Mittel im Wesentlichen konstant ist und die erste und zweite Stufe (2, 3) gleichspannungsmäßig miteinander verkoppelt, und
- die Vorspannung (Vp) ist an einem ersten und zweiten Ausgang (5, 6) der Ladungspumpe (4) abgreifbar und einem ersten bzw. zweiten Anschluß (25, 26) des Koppelkondensators (Cp) erdfrei zugeführt.

2. Zweistufiger Verstärker (1) nach Anspruch 1, **dadurch gekennzeichnet, daß** die Höhe der Vorspannung (Vp) durch eine der Ladungspumpe (4) zugeführte Referenzspannung (ur) und/oder Signalspannung (U1) definiert ist.

3. Zweistufiger Verstärker (1) nach Anspruch 2, **dadurch gekennzeichnet, daß** die Höhe der Vorspannung (Vp) durch ein festes Verhältnis zur Referenzspannung (ur) und oder Signalspannung (U1) definiert ist.

4. Zweistufiger Verstärker (1) nach einem der Ansprüche 1 bis 3, **dadurch gekennzeichnet, daß** die erste Stufe (2) ein Transkonduktanzverstärker ist und der mit dem zweiten Anschluß (26) des Koppelkondensators (Cp) verbundene Eingang der zweiten Stufe (3) als ein dominater Pol ausgebildet ist.

5. Zweistufiger Verstärker (1) nach Anspruch 4, **dadurch gekennzeichnet, daß** die kapazitive Wirkung des Einganges der zweiten Stufe (3) durch einen an den Eingang der zweiten Stufe (3) angeschlossenen Kompensationskondensator (Cc) vergrößert ist.

6. Zweistufiger Verstärker (1) nach einem der Ansprüche 1 bis 5, **dadurch gekennzeichnet, daß** die Strompfade zum ersten und zweiten Anschluß (25, 26) innerhalb der Ladungspumpe (4) mittels eines ersten und zweiten Kondensators (C1, C2) galvanisch aufgetrennt sind.

7. Zweistufiger Verstärker (1) nach einem der Ansprüche 1 bis 7, **dadurch gekennzeichnet, daß** die Mindestgröße des Koppelkondensators (Cp) in Abhängigkeit vom maximalen Ausgangsstrom (I1max) der ersten Stufe (2) und der Taktrate eines die Ladungspumpe (4) steuernden Taktes (T) derart bestimmt ist, daß innerhalb einer Halbtaktperiode die Ausgangsspannung der ersten Stufe (2) im Wesentlichen den erlaubten Aussteuerbereich nicht verläßt.

8. Zweistufiger Verstärker (1) nach Anspruch 5 **dadurch gekennzeichnet, daß** die Maximalgröße des Koppelkondensators (Cp) durch den Kompensationskondensator (Cc) derart bestimmt ist, daß der Koppelkondensator (Cp) insbesondere kleiner oder höchstens gleich groß wie der Kompensationskondensator (Cc) ist.

## Claims

1. A two-stage amplifier (1), whose first and second stages (2, 3) are connected in series through a coupling capacitor (Cp), with
- a charge pump (4), which generates a bias voltage (Vp) across the coupling capacitor (Cp), whose time average is essentially constant, and which DC-couples the first and second stage (2, 3), and such that
- the bias voltage (Vp) can be tapped at a first and second output (5, 6) of the charge pump (4) and is conducted floating to a first and second terminal (25, 26) respectively of the coupling capacitor (Cp).

2. The two-stage amplifier (1) of Claim 1, **characterized in that** the bias voltage (Vp) is defined by a signal voltage (U1) and/or a reference voltage (ur) conducted to the charge pump (4).

3. The two-stage amplifier (1) of Claim 2, **characterized in that** the bias voltage (Vp) is defined by a fixed ratio to the reference voltage ur and/or the signal voltage U1.

4. The two-stage amplifier (1) of one of the Claims 1 to 3, **characterized in that** the first stage (2) is a transconductance amplifier and that the input of the second stage (3), which is connected to the second terminal (26) of the coupling capacitor (Cp), is a dominant pole.

5. The two-stage amplifier (1) of Claim 4, **characterized in that** the capacitive effect of the input of the second stage (3) is increased by a compensation capacitor (Cc) connected to the input of the second stage (3).

6. The two-stage amplifier (1) of one of the Claims 1 to 5, **characterized in that** the current paths to the first and second terminal (25, 26) inside the charge pump (4) are DC-split by mean of a first and second capacitor (C1, C2).

7. The two-stage amplifier (1) of one of the Claims 1 to 7 [sic], **characterized in that** the minimum size of the coupling capacitor (Cp) is determined as a function of the maximum output current (I1max) of the first stage (2) and of the rate of a clock pulse (T), which controls the charge pump (4), in such a way that, within a half period of the clock pulse, the output voltage of the first stage (2) essentially does not leave the permitted modulation range.

8. The two-stage amplifier (1) of Claim 5, **characterized in that** the maximum size of the coupling capacitor (Cp) is determined by the compensation capacitor (Cc), in such a way that the coupling capacitor (Cp) is preferably smaller than or at most equal to the compensation capacitor (Cc).

## Revendications

1. Amplificateur à deux étages dont les premier et second étages sont connectés en série à travers un condensateur de couplage (Cp) avec :
- une pompe de charge (4), qui génère une tension (Vp) d'alimentation sur le condensateur de couplage (Cp) dont la moyenne temporelle est essentiellement constante et réalise le couplage à la tension continue des premier et second étages (2, 3) ;
- la tension d'alimentation (Vp) est produite entre une première et une seconde entrées de la pompe de charge (4) et une première et/ou une deuxième borne (5, 6) du condensateur de couplage (Cp) sont flottantes par rapport à la masse.

2. Amplificateur (1) à deux étages selon la revendication 1, **caractérisé en ce que** la valeur de la tension d'alimentation est définie au moyen de la pompe de charge (4) pilotée par une tension de référence (ur) et/ou par une tension de signal (U1).

3. Amplificateur (1) à deux étages selon la revendication 1, **caractérisé en ce que** la valeur de la tension d'alimentation (Vp) est définie par une proportion fixe de la tension de référence (ur) et/ou de la tension de signal (U1).

4. Amplificateur (1) à deux étages selon l'une des revendications 1 à 3, **caractérisé en ce que** le premier étage (2) est un amplificateur en transconductance et **en ce que** l'entrée du second étage (3) connectée à la deuxième borne (26) du condensateur de couplage (Cp) est configurée sur un pôle dominant.

5. Amplificateur (1) à deux étages selon la revendication 4, **caractérisé en ce que** la liaison capacitive de l'entrée du second étage (3) est augmentée par la connexion d'un condensateur de compensation (Cc) à l'entrée du second étage (3).

6. Amplificateur (1) à deux étages selon l'une des revendications 1 à 5, **caractérisé en ce que** les chemins de courant des première et seconde bornes (25, 26) à l'intérieur de la pompe de charge (4) sont interrompus galvaniquement au moyen d'un premier et d'un second condensateurs (C1, C2).

7. Amplificateur (1) à deux étages selon l'une des revendications 1 à 6, **caractérisé en ce que** la valeur minimale du condensateur de couplage (Cp) est déterminée en relation avec la valeur maximale du courant de sortie (I1max) du premier étage (2) et du taux fréquentiel de l'horloge de pilotage (7) de la pompe de charge (4) et **en ce que** la tension de sortie du premier étage (2) à l'intérieur d'une demie période d'horloge ne sort pratiquement pas de la dynamique admise.

8. Amplificateur (1) à deux étages selon la revendication 5, **caractérisé en ce que** la valeur maximale du condensateur de couplage (Cp) est déterminée par le condensateur de compensation (Cc) selon que le condensateur de couplage (Cp) est plus petit, respectivement plus grand, que le condensateur de compensation (Cc).
